# FASCICULE DE BREVET EUROPEEN

(11) **EP 1 688 753 B1**
(45) Date de publication et mention de la délivrance du brevet: **23.09.2009**
(21) Numéro de dépôt: 06290205.1
(22) Date de dépôt: 06.02.2006
(51) Int. Cl.: G01R 31/3185

(54) **Sécurisation du mode de test d'un circuit intégré**
Sicherung des Testmodus eines integrierten Schaltkreises
Protection of the test mode of an integrated circuit

(30) Priorité: 08.02.2005 FR 0501266
(43) Date de publication de la demande: 09.08.2006
(73) Titulaire: STMICROELECTRONICS SA, 92120 Montrouge (FR)
(72) Inventeur: Bancel, Fréderic, 13113 Lamanon (FR); Hely, David, 13170 Les Pennes Mirabeau (FR)
(74) Mandataire: Bentz, Jean-Paul

(56) Documents cités:
- US-A- 5 150 044
- US-A1- 2004 083 414
- HELY D ET AL: "Scan design and secure chip" ON-LINE TESTING SYMPOSIUM, 2004. IOLTS 2004. PROCEEDINGS. 10TH IEEE INTERNATIONAL FUNCHAL, MADEIRA ISLAND, PORTUGAL 12-14 JULY 2004, PISCATAWAY, NJ, USA,IEEE, 12 juillet 2004 (2004-07-12), pages 219-224, XP010714290 ISBN: 0-7695-2180-0

## Description

L'invention concerne, de façon générale, les circuits électroniques intégrés synchrones munis de moyens de logique combinatoire, de bascules, et de moyens de test.

Plus précisément, l'invention concerne un circuit électronique comprenant : plusieurs cellules logiques; plusieurs cellules configurables comprenant chacune un multiplexeur et une bascule; et plusieurs conducteurs de commande reliés aux cellules configurables et sur lesquels circulent sélectivement des signaux de commande émis en fonctionnement par un circuit de commande tel qu'un contrôleur d'accès. Les cellules configurables adoptent sélectivement, en fonction des signaux de commande, un mode de fonctionnement standard dans lequel elles sont fonctionnellement reliées à d'autres cellules logiques avec lesquelles elles coopèrent pour former un circuit logique, et un mode de test dans lequel ces cellules configurables sont fonctionnellement connectées en chaîne pour former un registre à décalage doté d'une entrée et d'une sortie de données.

Il est aujourd'hui bien connu de tester le fonctionnement correct des éléments fonctionnels d'un circuit intégré en imposant ou en déterminant, à des instants prédéfinis, des valeurs de données présentes en certains points internes de ce circuit intégré.

Une telle technique de test de chemins internes d'un circuit intégré (désignée par "scanpath" ou "internal scan method" en langue anglaise) est par exemple décrite dans la publication de M. Williams et J. Angel, intitulée "Enhancing Testability of LSI Circuits Via Test Points and Additional Logic, IEEE Transactions on Computers, vol. C-22, no.1; Janvier 1973".

Plus récemment, cette technique a été décrite dans l'article : D1 . XP010714290, Hely et al. : « Scan design and secure chip », On-Line Testing Symposium, 2004. IOLTS 2004. Proceedings. 10th IEEE International Funchal, Madeira Island, Portugal 12-14 July 2004, Piscataway, NJ, USA, IEEE, ISBN 0-7695-2180-0

Selon cette technique, chacune des bascules du circuit logique, dont il est utile de connaître l'état ou d'imposer le contenu durant le fonctionnement standard du circuit intégré, est dotée à son entrée d'un multiplexeur.

Les différentes bascules et les multiplexeurs qui leur sont associés constituent ainsi autant de cellules configurables dont les accès sont individuellement contrôlés par ces multiplexeurs.

Les multiplexeurs de ces différentes cellules configurables sont collectivement commandés par un contrôleur d'accès ou "contrôleur TAP" ("TAP" pour "Test Access Port" en langue anglaise) qui, en fonction d'un mode de fonctionnement choisi, utilise cet ensemble de cellules configurables soit comme un circuit fonctionnel standard, intégré au circuit logique qu'il forme avec les cellules logiques, soit comme un circuit de test.

Pour ce faire, le contrôleur TAP adresse sur différents conducteurs de commande, par lesquels il est relié aux différentes cellules configurables, des signaux de commande, tels qu'un signal de commande de mode, un signal de commande de chaînage ou encore un signal de commande de propagation de données, qui modifient les chemins de circulation des données au sein du circuit intégré et qui permettent ainsi la capture de ces données par le contrôleur, en vue de leur analyse.

En mode de fonctionnement standard, le contrôleur TAP pilote donc les multiplexeurs des cellules configurables de manière que les bascules de ces cellules soient connectées à des cellules logiques environnantes pour définir un ou plusieurs sous-ensembles fonctionnels du circuit intégré.

Dans le mode de test, qui est normalement déclenché à réception par le contrôleur TAP d'une commande d'exécution de test, ce contrôleur produit un signal de commande de chaînage pour connecter en série les bascules des cellules configurables de manière à former un registre à décalage.

Ce registre comporte notamment une entrée série et une sortie série respectivement connectées à une sortie et à une entrée du contrôleur TAP, ainsi qu'une entrée d'horloge recevant un signal d'horloge pour cadencer le flot de données.

Dans un premier temps, le contrôleur TAP charge en série des données dans les bascules des cellules configurables par l'entrée du registre à décalage que forment ces cellules.

Puis, le contrôleur TAP change la commutation des multiplexeurs pour former le circuit fonctionnel, et commande l'exécution d'un ou plusieurs cycles d'horloge par ce circuit fonctionnel. Les données chargées dans les bascules des cellules configurables sont alors traitées par le circuit fonctionnel.

Le contrôleur change alors une nouvelle fois la commutation des multiplexeurs pour former à nouveau le registre à décalage et récupère, en série sur la sortie du registre à décalage, les données mémorisées dans les bascules des cellules configurables durant le dernier cycle d'horloge.

En dépit de l'intérêt confirmé de cette technique de test, son application pratique peut en certaines circonstances s'avérer problématique, notamment sur les circuits intégrés qui traitent des données secrètes.

En effet, dans la mesure où l'activation du mode de test peut permettre à un fraudeur de lire le contenu des bascules des cellules configurables, cette technique de test présente a priori l'inconvénient de rendre de tels circuits très vulnérables à une utilisation frauduleuse.

Par exemple, en stoppant un processus de chargement interne de données secrètes dans le circuit intégré et en déchargeant le contenu du registre à décalage, un fraudeur peut déterminer que les cellules dont les bascules changent d'état contiennent les données secrètes. Un déchargement du registre à décalage à un moment opportun permet alors au fraudeur de récupérer les données secrètes.

En activant le mode de test, un fraudeur pourra également accéder en écriture aux bascules des cellules configurables pour insérer des données frauduleuses, ou bien pour placer le circuit intégré dans une configuration non autorisée. Il pourra ainsi par exemple accéder à un registre contrôlant un organe sécuritaire tel qu'un capteur ou bien le désactiver. Il pourra également injecter une donnée erronée en vue d'obtenir de l'information sur une donnée secrète.

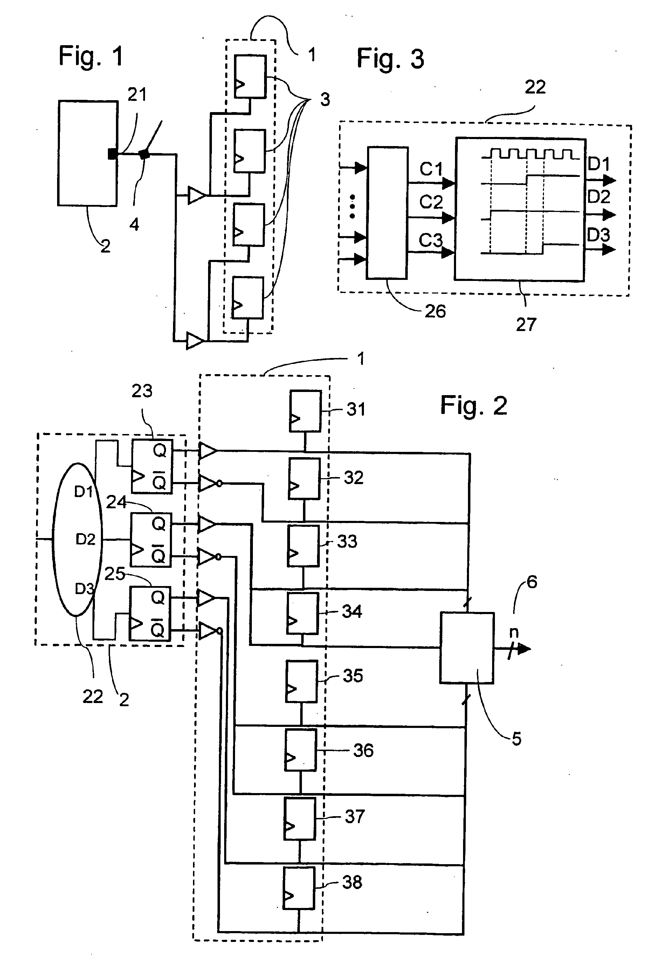

La fraude peut en fait adopter deux stratégies différentes. La première stratégie consiste à prendre le contrôle du contrôleur TAP et à observer sur les plots externes le contenu des cellules du registre à décalage. La seconde stratégie consiste à prendre le contrôle des cellules configurables en les excitant par micro-sondage de manière à simuler le pilotage de ces cellules par les signaux de commande qu'émet le contrôleur TAP, comme illustré à la figure 1. Un micro-sondage d'une seule cellule permet alors d'obtenir l'ensemble des données disposées en amont dans le registre à décalage. Si les cellules du registre à décalage sont synchrones, une prise de contrôle de l'horloge de test ne sera même pas nécessaire, l'horloge de mode de fonctionnement standard permettant de générer le décalage.

Un fraudeur peut identifier relativement aisément une des cellules 3 appartenant au registre à décalage 1, puis son entrée recevant le signal de commande du contrôleur TAP 2. Il est alors relativement aisé de suivre la piste électrique reliant cette entrée pour aboutir à la source du signal de commande du contrôleur TAP (sortie du contrôleur TAP 21 ou plot de connexion d'un contrôleur TAP). Une microsonde 4 appliquée au niveau de la source du signal de commande permet alors de simuler un mode de test avec l'ensemble des cellules du registre à décalage.

Il existe donc un besoin pour un circuit électronique qui résolve un ou plusieurs de ces inconvénients. L'invention porte ainsi sur un circuit électronique, comprenant :
- un circuit logique présentant une pluralité de cellules logiques ;
- des cellules de mémorisation susceptibles de former un registre à décalage, susceptibles d'être connectées aux cellules logiques, et présentant des bornes de réception de signaux de commande respectifs propres à inscrire des données dans les cellules et à lire des données inscrites dans les cellules;
- un contrôleur d'accès présentant plusieurs sorties connectées aux bornes de réception de signaux de commande de cellules de mémorisation respectives et appliquant un signal de commande distinct sur chacune de ces sorties ;
- un module de scrutation mesurant le signal entre une sortie du contrôleur d'accès et une borne de réception, déterminant si le signal mesuré diffère un signal attendu, et bloquant la formation du registre à décalage si une différence est déterminée, ce module de scrutation générant les attendus selon la même logique générant les signaux attendus selon la même logique que le contrôleur d'accès.

Selon une autre variante, un circuit d'horloge applique un signal d'horloge sur l'entrée d'horloge de chaque cellule de mémorisation après que le plus tardif des signaux de commande déphasés ait été généré.

Selon encore une variante, le contrôleur d'accès applique un signal et son complément sur différentes sorties.

Selon encore une autre variante, le contrôleur d'accès comprend en outre des bascules Flip-Flop dont les sorties *Q* et *Q̅* sont connectées aux sorties respectives du contrôleur d'accès.

Selon encore une variante, le contrôleur d'accès comprend une machine d'état intervenant dans la génération des signaux de commande appliqués sur les sorties du contrôleur d'accès.

Selon une autre variante, la machine d'état reçoit en entrée un code de validation de mode de test et/ou des signaux d'état de fonctionnement du circuit électronique.

Selon encore une autre variante, le module de scrutation génère des signaux attendus selon la même logique que le contrôleur d'accès et compare les signaux attendus aux signaux mesurés.

Selon une variante, le module de scrutation comprend une machine d'état intervenant dans la génération des signaux attendus.

Selon une autre variante, le module de scrutation commande une coupure d'alimentation du circuit électronique, une réinitialisation du circuit électronique et/ou l'effacement du contenu des cellules de mémorisation lorsqu'un signal mesuré diffère d'un signal attendu.

D'autres caractéristiques et avantages de l'invention ressortiront clairement de la description qui en est faite ci-après, à titre indicatif et nullement limitatif, en référence aux dessins annexés, dans lesquels :
- la figure 1 représente un circuit intégré selon l'art antérieur subissant une simulation frauduleuse de test par microsonde ;
- la figure 2 représente un exemple de circuit intégré selon l'invention ;
- la figure 3 représente un exemple de contrôleur TAP selon l'invention ;

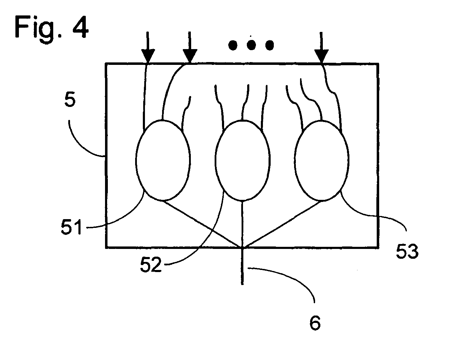

- la figure 4 représente un exemple de module de scrutation selon l'invention.

L'invention propose de générer plusieurs signaux de commande des cellules de mémorisation distincts sur des sorties du contrôleur d'accès. Un module de scrutation mesure les signaux de commande entre les sorties et les bornes de réception des cellules de mémorisation. Le module de scrutation bloque la formation du registre à décalage si le signal mesuré diffère du signal de commande correspondant appliqué sur la sortie du contrôleur d'accès.

L'invention oblige donc le fraudeur à placer plusieurs microsondes pour basculer le registre à décalage d'un mode de fonctionnement normal à un mode de fonctionnement de test. Plus le nombre de microsondes nécessaire est important, plus la réalisation de cette fraude devient difficile. En effet, le nombre de microsondes que l'on peut appliquer sur un circuit est limité et la gestion de la synchronisation de plusieurs sondes s'avère ardue. La sécurité du mode de test est ainsi accrue.

La figure 2 illustre un exemple de circuit électronique comprenant un contrôleur d'accès 2 et un module de scrutation 5 selon l'invention. Le circuit électronique présente des cellules logiques (non illustrées) et des cellules de mémorisation 31 à 38 aptes à former un registre à décalage 1 et à être connectées aux cellules logiques. Les cellules de mémorisation 31 à 38 présentent des bornes réceptionnant des signaux de commande respectifs pour commander leur lecture ou leur écriture. Les bornes de réception des signaux de commande sont connectées à des sorties du contrôleur d'accès 2.

Le contrôleur d'accès 2 comprend une machine d'état 22 générant plusieurs signaux intermédiaires D1, D2, D3 distincts. Les signaux intermédiaires D1, D2 et D3 sont notamment déphasés les uns par rapport aux autres. Un exemple de mise en oeuvre de la machine d'état sera décrit plus précisément en référence à la figure 3.

Les signaux intermédiaires D1, D2 et D3 sont appliqués respectivement sur l'entrée des bascules Flip-Flop 23 à 25. Les sorties *Q* et *Q̅* des bascules 23 à 25 forment les sorties du contrôleur d'accès 2. Ainsi, à chaque coup d'horloge, les bascules 23 à 25 reproduisent les signaux D1 à D3 ainsi que leurs compléments sur des sorties du contrôleur d'accès 2. Les signaux de commande générés par le contrôleur d'accès 2 se distinguent ainsi par leur déphasage et par leur niveau logique.

Des inverseurs sont disposés sur les entrées des cellules dont la borne de réception est connectée à une sortie *Q̅* d'une bascule. Les bornes de réception des cellules de mémorisation sont connectées de la façon suivante aux sorties du contrôleur d'accès 2 :
Cellule 31 : Bascule 23, sortie *Q* ;
Cellule 32 : Bascule 23, sortie *Q̅* ;
Cellule 33 : Bascule 24, sortie *Q* ;
Cellule 34 : Bascule 24, sortie *Q* ;
Cellule 35 : Bascule 24, sortie *Q̅* ;
Cellule 36 : Bascule 24, sortie *Q̅* ;
Cellule 37 : Bascule 25, sortie *Q* ;
Cellule 38 : Bascule 25, sortie *Q̅* .

Ainsi, des bornes de réception distinctes peuvent être connectées à une sortie commune du contrôleur d'accès 2.

La figure 3 détaille la génération des signaux intermédiaires D1 à D3 dans la machine d'état 22.

Des signaux sont appliqués sur des entrées d'un circuit de logique combinatoire 26. Ce circuit 26 génère des signaux C1 à C3 correspondant à des combinaisons logiques entre les signaux d'entrée. Les signaux C1 à C3 sont appliqués sur l'entrée d'un bloc de séquencement 27. Ce bloc 27 déphase les signaux C1 à C3 entre eux d'un ou plusieurs cycles d'horloge et fournit en sortie les signaux intermédiaires D1 à D3.

Les signaux appliqués à l'entrée du circuit 26 sont par exemple les bits d'un registre d'authentification, des signaux d'un état particulier de fonctionnement du circuit électronique et/ou le signal d'activation du mode de test Shift_DR. Les bits du registre d'authentification correspondent à un code de verrouillage connu seulement des personnes autorisées, et inscrit dans le registre d'authentification lorsque le circuit est en mode fonctionnel.

L'utilisation d'un circuit de logique combinatoire 26 générant plusieurs signaux C1 à C3 et d'un bloc de séquencement 27 rend la prise de contrôle du contrôleur d'accès 2 particulièrement ardue pour un fraudeur. En effet, la génération des différents signaux de sortie est alors relativement indépendante. Le fraudeur ne pourra alors pas générer l'ensemble des signaux de commande en se contentant d'appliquer une unique microsonde d'excitation dans le contrôleur d'accès 2.

Le module de scrutation 5 mesure les signaux appliqués sur les connexions entre une sortie du contrôleur d'accès 2 et une borne de réception. Plus le point de mesure est proche de la borne de réception, plus le module de scrutation sera à même de détecter une modification frauduleuse du signal sur la connexion. Dans l'exemple illustré, chaque point de mesure est disposé au niveau de la borne de réception d'une cellule de mémorisation. Cependant, pour ne pas créer un nombre trop important de points de mesure, l'homme du métier pourra disposer certains points de mesure sur des branches de connexion communes à plusieurs bornes de connexion.

Le module de scrutation 5 compare les signaux mesurés à des signaux attendus. Le module de scrutation peut générer les signaux attendus en utilisant la même logique que le contrôleur d'accès 2. Le module de scrutation 5 détermine une tentative de fraude lorsqu'un signal mesuré diffère du signal attendu correspondant.

Le module de scrutation 5 peut également utiliser une logique inverse et déterminer des signaux d'entrée de la machine d'état 22 qui aboutissent aux signaux de commande mesurés. Le module de scrutation mesure alors la valeur réelle des signaux d'entrée de la machine d'état 22. Si la valeur réelle et la valeur déterminée diffèrent, le module de scrutation 5 détermine une tentative de fraude.

Le module de scrutation 5 peut bloquer la formation du registre à décalage 1 par tout moyen approprié : coupure de l'alimentation d'un ou plusieurs composants du circuit électronique, réinitialisation du circuit électronique et/ ou effacement du contenu de certaines cellules de mémorisation. Si une fraude est détectée, le module de scrutation génère un signal correspondant sur la sortie 6.

Un passage frauduleux en mode de test est alors particulièrement ardu : le fraudeur devrait générer les différents signaux de commande attendus pour pouvoir tromper le module de scrutation. Cette fraude est particulièrement ardue lorsque les différents signaux de commande sont déphasés. De plus, même si les microsondes sont placées entre les points de mesure et les bornes de réception, leur nombre doit alors être très élevé du fait de la démultiplication des branches partant d'une sortie du contrôleur d'accès. Placer efficacement suffisamment de microsondes sera alors en pratique impossible.

Un exemple de module de scrutation 5 est illustré à la figure 3. Le module de scrutation 5 reçoit en entrée les signaux de différents points de mesure. Ces signaux sont appliqués sur les entrées de trois machines d'état 51 à 53. A partir des signaux mesurés, le module de scrutation génère des signaux intermédiaires correspondants. En comparant les signaux générés aux signaux intermédiaires D1 à D3 attendus, le module de scrutation détecte une éventuelle fraude. Bien qu'on ait illustré une machine d'état par signal intermédiaire à tester, une seule et même machine d'état peut mettre en oeuvre les mêmes fonctions.

Lorsque les signaux de commande sont déphasés, les différentes cellules de mémorisation devant former le registre à décalage en mode de test sont synchronisées. On prévoit par exemple d'appliquer un signal d'horloge externe sur l'entrée d'horloge de chaque cellule de mémorisation. Un utilisateur applique ainsi un signal d'horloge sur ces entrées d'horloge lorsqu'il est certain que tous les signaux de commande déphasés ont été appliqués sur les bornes de réception, c'est-à-dire à la fin de la période transitoire durant laquelle seulement certains signaux de commande sont appliqués. On peut également prévoir que l'application d'un signal d'horloge interne sur les entrées d'horloge des cellules soit bloquée jusqu'à la fin de la période transitoire.

Les cellules de mémorisation peuvent présenter une structure bien connue de l'homme du métier. Les cellules de mémorisation peuvent notamment comprendre un multiplexeur modifiant la connexion de l'entrée d'une bascule en fonction du mode de fonctionnement choisi.

## Revendications

1. Circuit électronique, comprenant :
- un circuit logique présentant une pluralité de cellules logiques ;
- des cellules de mémorisation (31-38) susceptibles de former un registre à décalage (1), susceptibles d'être connectées aux cellules logiques, et présentant des bornes de réception de signaux de commande respectifs propres à inscrire des données dans les cellules logiques et à lire des données inscrites dans les cellules logiques;
- un contrôleur d'accès (2) présentant plusieurs sorties connectées aux bornes de réception de signaux de commande de cellules de mémorisation respectives et appliquant un signal de commande distinct sur chacune de ces sorties ;
**caractérisé en ce qu'**il comprend en outre :
- un module de scrutation (5) mesurant le signal entre une sortie du contrôleur d'accès et une borne de réception, déterminant si le signal mesuré diffère d'un signal attendu, et bloquant la formation du registre à décalage si une différence est déterminée,
- et **en ce que** ce module (5) de scrutation génère les signaux attendus selon la même logique que le contrôleur d'accès.

2. Circuit électronique selon la revendication 1, dans lequel le contrôleur d'accès (2) déphase les signaux de commande générés les uns par rapport aux autres.

3. Circuit électronique selon la revendication 2, comprenant un circuit d'horloge appliquant un signal d'horloge sur l'entrée d'horloge de chaque cellule de mémorisation après que le plus tardif des signaux de commande déphasés ait été généré.

4. Circuit électronique selon l'une quelconque des revendications précédentes, dans lequel le contrôleur d'accès (2) applique un signal et son complément sur différentes sorties.

5. Circuit électronique selon la revendication 4, dans lequel le contrôleur d'accès (2) comprend en outre des bascules Flip-Flop (23-25) dont les sorties *Q* et *Q̅* sont connectées aux sorties respectives du contrôleur d'accès.

6. Circuit électronique selon l'une quelconque des revendications précédentes, dans lequel le contrôleur d'accès comprend une machine d'état (22) intervenant dans la génération des signaux de commande appliqués sur les sorties du contrôleur d'accès.

7. Circuit électronique selon la revendication 6, dans lequel la machine d'état reçoit en entrée un code de validation de mode de test et/ou des signaux d'état de fonctionnement du circuit électronique.

8. Circuit électronique selon la revendication 6, dans lequel le module de scrutation (5) comprend une machine d'état intervenant dans la génération des signaux attendus.

9. Circuit électronique selon la revendication 8, dans lequel le module de scrutation commande une coupure d'alimentation du circuit électronique, une réinitialisation du circuit électronique et/ou l'effacement du contenu des cellules de mémorisation lorsqu'un signal mesuré diffère d'un signal attendu.

## Claims

1. An electronic circuit, including:
- a logic circuit presenting a plurality of logic units;
- memory units (31-38) suitable for forming a shift register (1), suitable for being connected to the logic units, and presenting terminals for reception of their respective control signals to write data into the logic units and to read the data written in the logic units;
- an access controller (2) with a plurality of outputs connected to the control signal reception terminals of the respective memory units and applying a separate control signal to each one of these outputs;
**characterized in that** it further comprises:
- a scrutinizing module (5) measuring the signal between an output of the access controller and a reception terminal, determining if the measured signal differs from an expected signal and blocking the formation of the shift register if a difference is determined.
- and **in that** this scrutinizing module (5) generates the expected signals according to the same logic as the access controller.

2. An electronic circuit according to claim 1, wherein the access controller (2) phase-shifts the control signals generated in relation to each other.

3. An electronic circuit according to claim 2, including a clock circuit applying a clock signal to the clock input of each memory unit after the last phase-shifted control signals have been generated.

4. An electronic circuit according to any one of the preceding claims, wherein the access controller (2) applies a signal and its complement to various outputs.

5. An electronic circuit according to claim 4, wherein the access controller (2) also includes flip-flop circuits (23-25), of which the outputs Q and Q-bar are connected to the respective outputs of the access controller.

6. An electronic circuit according to any one of the preceding claims, wherein the access controller includes a state machine (22) intervening in the generation of the control signals applied to the outputs of the access controller.

7. An electronic circuit according to claim 6, wherein the state machine receives, at input, a test mode validation code and/or functioning state signals from the electronic circuit.

8. An electronic circuit according to claim 6, wherein the scrutinizing module (5) includes a state machine intervening in the generation of the expected signals.

9. An electronic circuit according to claim 8, wherein the scrutinizing module orders a power cut-off of the electronic circuit, a re-initialization of the electronic circuit and/or the erasure of the contents of the memory units when a measured signal differs from an expected signal.

## Patentansprüche

1. Elektronischer Schaltkreis, umfassend:
- eine Logikschaltung, die mehrere Logikbausteine umfasst,
- Speicherungszellen (31-38), in der Lage, ein Schieberegister (1) zu bilden, geeignet, an die Logikbausteine angeschlossen zu werden, und Empfangsanschlüsse für Steuersignale aufweisend, die zum Eintragen von Daten in die Logikbausteine dienen bzw. zum Lesen der Daten, die in die Logikbausteine eingetragen sind,
- eine Zugriffssteuerung (2), die mehrere Ausgänge aufweist, die mit den Empfangsanschlüssen für Steuersignale entsprechender Speicherungszellen verbunden sind und an jeden dieser Ausgänge ein unterschiedliches Steuersignal anlegen,
**dadurch gekennzeichnet, dass**
- ein Abfragemodul (5), das das Signal zwischen einem Ausgang der Zugriffssteuerung und einem Empfangsanschluss misst und bestimmt, ob sich das gemessene Signal von einem erwarteten Signal unterscheidet, und die Bildung des Schieberegisters blockiert, wenn ein Unterschied festgestellt wird,
- und **dadurch**, dass dieses Abfragemodul (5) die erwarteten Signale nach derselben Logik erzeugt, wie die Zugriffssteuerung.

2. Elektronischer Schaltkreis nach Patentanspruch 1, in dem die Zugriffssteuerung (2) die erzeugten Steuersignale gegeneinander phasenverschiebt.

3. Elektronischer Schaltkreis nach Patentanspruch 2, eine Taktschaltung umfassend, die ein Taktsignal an den Takteingang jeder Speicherungszells anlegt, nachdem das letzte der phasenverschobenen Steuersignale erzeugt wurde.

4. Elektronischer Schaltkreis nach irgendeinem der vorangehenden Patentansprüche, in dem die Zugriffssteuerung (2) an verschiedene Ausgänge ein Signal und seine Negation anlegt.

5. Elektronischer Schaltkreis nach Patentanspruch 4, in dem die Zugriffssteuerung (2) außerdem Flipflops (23-25) umfasst, deren Ausgänge Q und Q̅ an die entsprechenden Ausgänge der Zugriffssteuerung angeschlossen sind.

6. Elektronischer Schaltkreis nach irgendeinem der vorangehenden Patentansprüche, in dem die Zugriffssteuerung eine Zustandsmaschine (22) umfasst, die an der Erzeugung der Steuersignale beteiligt ist, die an die Ausgänge der Zugriffssteuerung angelegt werden.

7. Elektronischer Schaltkreis nach Patentanspruch 6, in dem die Zustandsmaschine am Eingang einen Code zur Validierung eines Testmodus empfängt und/oder Signale über den Betriebszustand des elektronischen Schaltkreises.

8. Elektronischer Schaltkreis nach Patentanspruch 6, in dem das Abfragemodul (5) eine Zustandsmaschine umfasst, die an der Erzeugung der erwarteten Steuersignale beteiligt ist.

9. Elektronischer Schaltkreis nach Patentanspruch 8, in dem das Abfragemodul eine Unterbrechung der Stromversorgung des elektronischen Schaltkreises veranlasst, eine Reinitlalisierung des elektronischen Schaltkreises und/oder die Löschung des Inhalts der Speicherungszellen, wenn sich ein gemessenes Signal von einem erwarteten Signal unterscheidet.
